# DEMANDE DE BREVET EUROPEEN

(11) **EP 2 400 555 A1**
(43) Date de publication de la demande: **28.12.2011**
(21) Numéro de dépôt: 11171125.5
(22) Date de dépôt: 23.06.2011
(51) Int. Cl.: H01L 31/0224, H01L 31/0296, H01L 31/0392, H01L 31/072, H01L 31/18, C03C 17/34, C03C 17/36

(54) **Cellule comprenant un materiau photovoltaïque à base de cadmium**

(30) Priorité: 25.06.2010 FR 1055106
(71) Demandeur: Saint-Gobain Glass France, 92400 Courbevoie (FR)
(72) Inventeur: Charlet, Emilie, 75011 PARIS (FR); Peter, Emmanuelle, 75012 PARIS (FR)
(74) Mandataire: Teyssedre, Laurent

(57) **Abrégé**

Cellule photovoltaïque (100) comprenant au moins un substrat transparent verrier (10), protégeant un empilement de couches (30) comprenant au moins:
- un film (5) incorporant au moins un matériau à base de Cadmium et à propriétés photovoltaïques,
- deux couches (3, 6) formant électrodes de part et d'autre de ladite couche photovoltaïque (5), l'une inférieure (3) disposée la plus proche du substrat et l'autre supérieure (6),

au moins ladite couche électrode inférieure (3) étant un oxyde transparent conducteur du type TCO,
ladite cellule se caractérisant en qu'elle comprend, entre ladite couche électrode inférieure (3) et ledit film photovoltaïque (5), au moins une couche (4) constituée essentiellement d'un nitrure de gallium GaN, éventuellement partiellement substituée par de l'aluminium Al, ladite couche étant d'épaisseur physique strictement inférieure à 20 nm.

## Description

L'invention concerne une nouvelle cellule photovoltaïques, incorporant dans sa structure un empilement de couches, ledit empilement incorporant au moins un film photovoltaïque à base de Cadmium.

De façon connue, un module photovoltaïque est constituée d'un ensemble de cellules photovoltaïques, également appelées modules photovoltaïques, souvent couplées en série les unes aux autres. Ces cellules ou modules génèrent un courant continu lorsqu'elles sont exposées à la lumière. Pour fournir une puissance adaptée qui correspond à une énergie suffisante et attendue, on réalise des surfaces suffisamment étendues d'une multitude de modules photovoltaïques. Ces modules peuvent être intégrés sur les toits des habitations ou des locaux commerciaux ou disposés dans des champs pour la production d'énergie centralisée. Diverses technologies existent dans la réalisation des cellules photovoltaïques. Les cellules les plus répandues intègrent comme matériau photosensible photovoltaïque un ensemble de semi-conducteurs dopé n et p, en particulier de semi-conducteurs à base de silicium cristallin ou de semi-conducteurs en couches minces.

Classiquement, un module photovoltaïque comprend ainsi un substrat servant de support et un matériau dit photovoltaïque qui est le plus souvent constitué d'un empilement de semi-conducteurs dopés n et p, formant dans leur zone de contact électrique une jonction p-n. Un autre substrat, sur la face opposée, assure la protection du matériau photovoltaïque. Parmi ces deux substrats, on dénomme substrat avant ou substrat de face avant celui qui est destiné à être en regard de l'énergie lumineuse reçue. Ce substrat de face avant est de préférence un verre minéral transparent présentant une transmission lumineuse très élevée dans la gamme de rayonnement 300 à 1250 nm. Il est le plus souvent traité thermiquement (c'est-à-dire recuit, trempé ou durci) pour pouvoir résister aux intempéries, en particulier la grêle, et cela de manière durable dans le temps (25 à 30 ans). De chaque coté du matériau photovoltaïque sont disposées des électrodes constituées par des matériaux électriquement conducteurs qui constituent les bornes positives et négatives de la cellule photovoltaïque. De façon connue, les deux électrodes (anode et cathode) du module photovoltaïque permettent de collecter le courant produit sous l'effet de la lumière dans le matériau photovoltaïque, le transport et la ségrégation des charges étant dus à la différence de potentiel créée entre les parties respectivement dopée p et n des semi-conducteurs. Un exemple d'un tel module est par exemple décrit dans la demande WO2006/005889, à laquelle on se référera pour les détails de la réalisation.

Si le silicium cristallin offre en tant que semi-conducteur un bon rendement énergétique, et constitue la première génération des cellules photovoltaïques sous forme de « Wafers », on s'intéresse de plus en plus dans l'industrie à la technologie dite « couches minces ». Selon cette technologie, le matériau siège de l'activité photovoltaïque est cette fois directement déposé sur le substrat sous la forme de couches ou films plus ou moins épais.

Ce matériau comprend ou est généralement constitué de silicium amorphe (a-Si) ou microcristallin (µc-Si), ou encore est à base de cadmium suivant notamment une hétérojonction n/p du type CdS/CdTe, appelé tellure de cadmium ou CdTe dans la présente description, ou encore à base de chalcopyrites (CIS, CIGS, CiGSe₂).

L'épaisseur réduite de ces matériaux déposés en couche mince offre théoriquement la possibilité de réduire les coûts de production des cellules. La fabrication de modules sur des substrats verriers, découpés à la taille finale des modules, comporte ainsi le dépôt d'une succession de couches minces déposées l'une après l'autre sur le substrat, dont au moins :
- une couche servant d'électrode avant transparente au rayonnement incident,
- les différentes couches minces constituant le matériau photovoltaïque lui-même, désignés par le terme « couche (ou film) photovoltaïque » dans la présente description et
- une couche mince servant d'électrode arrière réfléchissante.

Dans la description et dans les revendications, on désigne également par les termes « inférieur » et « supérieur » les positions respectives des couches les unes par rapport aux autres et par référence au substrat verrier de face avant. De même, on désigne comme sur-couche une couche disposée au dessus de la couche d'électrode (TCO) par référence au substrat verrier de face avant et comme sous-couche une couche disposée au dessous de la couche d'électrode (TCO) toujours par référence au substrat verrier de face avant.

Les cellules photovoltaïques, quant à leur taille et aux connexions électriques à établir entre elles, sont réalisées par des étapes intermédiaires de gravure par laser entre chaque étape de dépôt de couche. Ces substrats verriers souvent trempés et intégrant les cellules photovoltaïques constituent ainsi les substrats de face avant des modules. Un substrat support de face arrière est ensuite rapporté par feuilletage contre la face pourvue de l'empilement de couches du substrat de face avant.

L'électrode agencée contre le substrat en verre de face avant du module est bien entendu transparente pour laisser passer l'énergie lumineuse jusqu'à la couche active photovoltaïque. Cette électrode comporte le plus souvent un oxyde transparent électro-conducteur qui est souvent appelé dans le domaine TCO (pour « Transparent Conductive Oxide »).

De façon connue, on utilise comme matériau, pour la fabrication de ces couches TCO, des couches fines en oxyde de zinc dopé à l'aluminium (AZO), en oxyde d'étain dopé à l'Indium (ITO), en oxyde d'étain dopé au fluor (SnO2 :F) ou encore en oxyde de zinc dopé au gallium (GZO) ou dopé bore (BZO), sans que cette liste soit cependant exhaustive.

Il faut bien noter que ces couches constituant les électrodes, notamment celles disposées en face avant, c'est-à-dire à proximité du substrat avant, sont des composants fonctionnels essentiels des cellules solaires en couche mince, car elles servent à collecter et évacuer les électrons ou trous formés par le rayonnement électromagnétique incident dans les couches semi-conductrices photovoltaïques. A ce titre, il est nécessaire pour l'application que leur résistivité soit la plus faible possible. Notamment, pour obtenir la conduction électrique souhaitée, ou plutôt la faible résistance souhaitée, le revêtement électrode à base de TCO doit être déposé à une épaisseur physique relativement importante, de l'ordre de quelques centaines de nanomètres, ce qui coûte cher eu égard au prix de ces matériaux lorsqu'ils sont déposés en couches minces, notamment par la technique de pulvérisation magnétron. L'inconvénient majeur des revêtements électrodes à base de TCO réside ainsi tout particulièrement dans le fait que l'épaisseur déposée du matériau est nécessairement un compromis entre sa conduction électrique finale et sa transparence finale après le dépôt. Autrement dit, plus l'épaisseur physique du matériau est importante, plus sa conductivité sera forte mais plus la transparence sera faible. Inversement, une épaisseur physique faible de la couche de TCO permet une meilleure transparence mais induit une conductivité électrique de la couche dégradée. Au final, il s'avère souvent difficile avec les revêtements TCO actuels d'optimiser indépendamment et de façon satisfaisante la conductivité du revêtement électrode du type TCO et sa transparence, notamment son absorption lumineuse et sa transmission lumineuse. On comprend également, dans ces conditions, que le contact électrique entre la couche TCO et la couche de matériau photovoltaïque revêt également une importance primordiale pour les propriétés finales de la cellule photovoltaïque.

Un autre problème lié à ces TCO provient de leur utilisation dans l'application spécifique en tant qu'électrode dans un module photovoltaïque : pour conférer au substrat verrier sa résistance mécanique, les substrats revêtus de la couche TCO doivent souvent subir un traitement thermique final, notamment une trempe. Par ailleurs, il est souvent nécessaire de chauffer la couche TCO pour en augmenter la cristallinité et par suite la conductivité et la transparence.

Alternativement, le dépôt de certaines couches photovoltaïques et notamment des couches à base de Cadmium du type CdTe ou CdS, nécessite une température de mise en oeuvre d'au moins 400°C et même pouvant aller jusqu'à 700°C. Pendant les trempes et/ou les chauffages successifs, l'empilement est ainsi au cumul porté, sous atmosphère ambiante ou autre, à des températures supérieures à 500 degrés, voire supérieures à 600°C, pendant quelques minutes. Malheureusement, lors de ces traitements thermiques, après une première phase bénéfique de diminution de leur résistivité électrique (ou de leur R/carré), la plupart des TCO voient au contraire leurs propriétés électriques se dégrader drastiquement, leur résistance électrique augmentant de façon exponentielle si le traitement thermique est prolongé au delà de quelques minutes. Sans que cela puisse être considéré comme une affirmation définitive, un tel phénomène s'expliquerait d'une part en raison de la migration des alcalins du verre par la surface de la couche TCO au regard du substrat et d'autre part par l'oxydation du TCO par l'oxygène contenu dans l'atmosphère selon l'autre surface.

Le document EP 1 362 834 propose d'améliorer la résistance des empilements aux traitements thermiques en y incorporant une couche de protection choisie parmi les oxydes, les oxynitrures et nitrures de métaux.

Dans la demande WO 2009/056732, il a déjà été proposé également de disposer, en plus d'une sous-couche barrière aux alcalins et d'une sur-couche empêchant l'oxydation, notamment en nitrure de silicium, une couche métallique additionnelle susceptible de s'oxyder lors du traitement thermique.

Ces deux techniques permettent une protection de la couche de TCO mais engendre cependant une efficacité dégradée de la cellule photovoltaïque, du fait de l'interposition de couches supplémentaires isolant la couche TCO de la couche photovoltaïque.

La demande WO 2009/156640 et le brevet US 6,169,246 indiquent l'utilisation d'une couche tampon, notamment d'un oxyde de zinc, d'étain ou d'un oxyde mixte de zinc et d'étain entre la couche TCO et la couche photovoltaïque, pour améliorer le fonctionnement de la cellule.

Si cette technique permet effectivement l'amélioration du fonctionnement de la cellule, elle ne résout pas le problème de la dégradation de la couche de TCO lors d'un traitement thermique prolongé du substrat.

La présente invention vise donc à pallier les inconvénients des techniques précédentes en proposant une solution comprenant un empilement tel que les propriétés tant optiques que de conduction électrique de la couche de TCO ne sont sensiblement pas affectées par les phases de traitement thermique, notamment lors du dépôt des couches CdTe/Cds et de chauffage successifs lors de la fabrication de la cellule photovoltaïque, et sont même améliorées par ces dernières, et tel que l'efficacité solaire de la cellule ne soit au final pas dégradée.

Plus précisément, la présente invention se rapporte à une cellule photovoltaïque comprenant au moins un substrat transparent verrier, protégeant un empilement de couches comprenant au moins :
- un film incorporant au moins un matériau à base de Cadmium et à propriétés photovoltaïques,
- deux couches formant électrodes de part et d'autre de ladite couche photovoltaïque, l'une inférieure disposée la plus proche du substrat et l'autre supérieure.

Selon l'invention, au moins ladite couche électrode inférieure est un oxyde transparent conducteur du type TCO.

Une cellule selon la présente invention se caractérise en qu'elle comprend, entre ladite couche électrode inférieure et ledit film photovoltaïque, une couche constituée essentiellement d'un nitrure de Gallium GaN, éventuellement partiellement substituée par de l'aluminium Al, ladite couche étant d'épaisseur physique strictement inférieure à 20 nm.

Dans une cellule photovoltaïque selon l'invention, la couche photovoltaïque comprend ou est constituée par des matériaux semi-conducteurs incorporant du cadmium, et notamment du du Tellure de cadmium, et comprenant par exemple une hétérojonction CdS/CdTe. Notamment, la couche ou le film photovoltaïque selon l'invention est à base d'un assemblage de couches comprenant préférentiellement au moins une couche de Tellure de Cadmium et/ou une couche de CdS. A titre d'exemple de combinaison possible pour la confection de la jonction hétérogène p-n, on pourra également se reporter au passage colonne 6 lignes 54-62 de la publication US 6169246.

Sans y être limitées, les cellules selon l'invention peuvent de préférence et optionnellement être conformes à au moins l'une des caractéristiques suivantes :
- La couche constituée essentiellement d'un nitrure de gallium GaN présente une épaisseur inférieure à 15 nm, de préférence inférieure à 12 nm. Il a été trouvé selon l'invention que des couches d'épaisseur proche de 3 nm, correspondant à la limite de détection du profilomètre DEKTAK VEECO utilisé pour la mesure, permettaient également de résoudre le problème technique précédemment exposé. Sans sortir du cadre de l'invention des épaisseurs de l'ordre de 1 ou 2 nm, notamment comprises entre 1 et 20 nm, voire entre 2 et 20 nm, doivent être considérées comme comprises dans le cadre de la présente invention.
- Le matériau à base de Cadmium et à propriétés photovoltaïques est du type CdS/CdTe.
- la cellule comprend en outre, entre la couche en nitrure d'aluminium et le film à propriétés photovoltaïques, une couche tampon, éventuellement dopée pour en augmenter la conductivité électrique, constituée d'un ou plusieurs matériaux par exemple choisis parmi l'oxyde d'étain SnO₂, l'oxyde de zinc ZnO, un oxyde mixte de zinc et d'étain de formulation générale SnₓZn_{y}O_{z}, comprenant également éventuellement de l'aluminium et/ou de l'antimoine Sb, ou un oxyde mixte d'indium et d'étain.
- L'épaisseur physique de la couche tampon, est comprise entre 20 et 300 nm, de préférence entre 150 et 200 nm.
- La couche électrode inférieure est un TCO comprenant ou constitué par l'oxyde de zinc ZnO dopé par un élément choisi dans le groupe Al, Ga, In, B, Ti, V, Y, Zr, Ge ou par une combinaison de ces différents dopants, de préférence un TCO constitué par l'oxyde de zinc ZnO dopé à l'aluminium AZO ou l'oxyde de zinc ZnO dopé au gallium GZO ou l'oxyde de zinc ZnO co-dopé au gallium et à l'aluminium.
- la couche électrode inférieure est un TCO comprenant ou constitué par un stannate de Cadmium, notamment Cd₂SnO₄.
- le nitrure de Gallium GaN constituant la couche est partiellement substitué par de l'aluminium Al, dans une proportion comprise entre 1 et 50% atomique.
- La cellule comprend entre ledit substrat et ladite couche électrode inférieure, au moins une couche de matériau diélectrique, constituée dans un matériau formant barrière aux alcalins issus du substrat verrier, notamment lors d'une trempe ou d'un recuit.
- La couche formant barrière aux alcalins comprend au moins un matériau choisi dans le groupe constitué par Si₃N₄, SnₓZn_{y}O_{z}, SiO₂, SiOₓN_{y}, TiO₂, Al₂O₃, ledit matériau étant éventuellement dopé notamment par un élément choisi parmi Al, Zr Sb.

Un mode de réalisation de la présente invention est décrit par la suite, sans qu'il puisse être considéré qu'il soit limitatif de la présente invention, sous aucun des aspects décrits, en relation avec l'unique figure annexée.

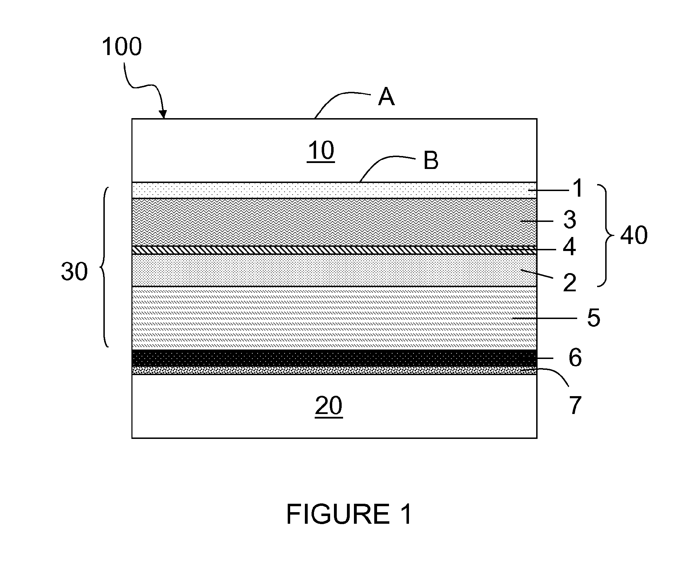

Il est représenté schématiquement sur la figure 1 une cellule photovoltaïque 100 selon la présente invention.

Cette cellule comprend en face avant, c'est-à-dire du coté exposé au rayonnement solaire, un premier substrat 10 transparent verrier dit de face avant. Ce substrat peut par exemple être entièrement dans un verre contenant des alcalins comme un verre silico-sodo-calcique.

L'essentiel de la masse (c'est-à-dire pour au moins 98 % en masse), voire la totalité du substrat à fonction verrière, est de préférence constituée de matériau(x) présentant la meilleure transparence possible au rayonnement dans la partie du spectre solaire utile à l'application comme module solaire, c'est-à-dire généralement la partie du spectre allant d'environ 300 à environ 1250 ou 1300 nm. Ainsi, le substrat transparent 10 choisi selon l'invention présente une transmission élevée pour le rayonnement électromagnétique d'une longueur d'onde de 300 à 1 300 nm et en particulier pour la lumière solaire. Le substrat verrier est en général choisi pour que sa transmission, dans cette gamme, soit supérieure à 75 % et en particulier supérieure à 85 % ou même supérieur à 95%. Ce substrat est avantageusement un verre extra clair, comme le verre Diamant® commercialisé par la société SAINT-GOBAIN, ou un verre présentant une texturation en surface, comme le verre Albarino® également commercialisé la société SAINT-GOBAIN.

Le substrat peut avoir une épaisseur totale allant de 0,5 à 10 mm et est notamment utilisé comme plaque protectrice d'une cellule photovoltaïque. Il peut dans ce but être avantageux de lui faire subir au préalable un traitement thermique tel qu'une trempe.

De manière conventionnelle, on définit par A la face avant du substrat 10 dirigée vers les rayons lumineux (la face externe) et par B la face arrière du substrat dirigée vers le reste des couches du module solaire (face interne).

La face B du substrat 10 est revêtue d'un empilement 30 de couches minces selon les modalités de l'invention.

Ainsi, au moins une portion de surface du substrat est revêtue sur sa face B d'au moins une couche 1 d'un matériau connu pour ses propriétés de barrière à la diffusion des alcalins à travers les différentes couches de l'empilement 30, notamment lorsque l'ensemble est porté à haute température, par exemple lors des différentes phases de trempe ou de recuit ou encore de dépôt à chaud, notamment lors du dépôt du film photovoltaïque 5 comprenant du Cadmium. La présence de cette couche barrière 1 en face B du substrat permet en particulier d'éviter, voire de bloquer, la diffusion des ions sodium du verre vers les couches actives supérieures.

Selon l'invention, la nature de cette couche n'est pas particulièrement limitée et toute couche connue à cet effet peut être utilisée. Notamment, cette couche barrière aux alcalins peut être à base d'un matériau diélectrique, choisi parmi les nitrures, oxydes ou oxynitrures de silicium, ou encore les nitrures, oxydes ou oxynitrures de zirconium. Il peut notamment s'agir de Si₃N₄, SnₓZn_{y}O_{z}, SiO₂, SiOₓN_{y}, TiO₂. Parmi tout ceux-ci, le nitrure de silicium Si₃N₄ permet notamment d'obtenir un excellent effet barrière aux alcalins. Cette couche barrière aux alcalins peut ne pas être stoechiométrique. Elle peut être de nature sous-stoechiométrique, voire sur-stoechiométrique.

La couche 1 n'est cependant pas forcément unique et il est envisagée dans le cadre de la présente invention de la remplacer par un ensemble de couches ayant cette même finalité de faire barrière aux alcalins. L'épaisseur de la couche barrière 1 (ou de l'ensemble des couches barrières) est comprise au total entre 3 et 200 nm, préférentiellement comprise entre 10 et 100 nm et notamment entre 20 et 50 nm.

Sur cette couche 1 et par exemple directement au contact de celle-ci, on dépose selon l'invention une couche électroconductrice 3 du type «Transparent Conductive Oxide» ou TCO. Cette couche 3 constitue l'électrode inférieure de la cellule photovoltaïque. La couche 3 est de préférence constituée par un matériau choisi parmi les oxydes de zinc dopés ou substitués par au moins un des éléments du groupe Al, Ga. En variante, il est également possible de choisir un élément dopant ou substituant choisi parmi In, B, Ge, Ti, V, Y, Zr. Sans sortir du cadre de l'invention, toute autre couche TCO connu à cet effet pourrait cependant également être utilisée, notamment du type précédemment décrit. En particulier, il est possible et également préféré selon l'invention d'utiliser une couche de TCO comprenant de l'étain et du Cadmium, sous la forme d'un stannate de Cadmium, par exemple Cd₂SnO₄.

Cette couche conductrice 3 doit être aussi transparente que possible, et présenter une transmission élevée de la lumière dans l'ensemble des longueurs d'onde correspondant au spectre d'absorption du matériau constituant la couche fonctionnelle, afin de ne pas réduire inutilement le rendement du module solaire. L'épaisseur de cette couche électro-conductrice est comprise entre 50 et 1500 nm, préférentiellement comprise entre 200 et 800 nm, et sensiblement voisine de 700 nm. La couche de TCO des substrats selon l'invention doit présenter une haute conductivité électrique, une haute transparence au rayonnement électromagnétique et en particulier à la lumière solaire.

La couche électro-conductrice 3 en TCO selon l'invention doit présenter une faible résistivité, c'est-à-dire de préférence une résistance par carré d'au plus 30 ohms/carré, notamment d'au plus 20 ohms/carré, voire d'au plus 10 ohms/carré dans le module photovoltaïque final, pour obtenir un rendement optimale de cette dernière.

Selon l'invention, la couche transparente d'oxyde électriquement conducteur TCO et de préférence au moins la couche barrière 1 sont déposées successivement et dans un même appareillage, par les techniques connues de dépôt de couches minces sous vide, en particulier par les techniques de pulvérisation habituelles dans le domaine du dépôt des couches minces, en particulier les techniques dites pulvérisation magnétron comme il sera plus en détail décrit par la suite.

Selon l'invention, la couche électro-conductrice servant d'électrode inférieure est ensuite recouverte selon l'invention d'une couche 4 de protection contre l'oxydation. Cette couche est constituée selon l'invention par un nitrure de gallium GaN et présente une épaisseur inférieure à 20 nm, de préférence inférieure à 15 nm ou même inférieure à 12 nm. Cette couche de GaN peut éventuellement comprendre, mais pas nécessairement, de l'Aluminium en substitution du Gallium, dans une proportion inférieure ou égale à 50% atomique, de préférence inférieure à 30% atomique. Par exemple, la couche de GaN peut comprendre de l'Aluminium en substitution du Gallium, dans une proportion inférieure à 20%, ou inférieure à 10% atomique. La quantité d'Aluminium en substitution du Gallium peut être par exemple supérieure à 1% atomique, voire supérieure à 2% atomique ou même supérieure à 5% atomique. Au sens de la présente invention, on entend par nitrure de Gallium GaN un nitrure comprenant essentiellement, voire exclusivement du gallium et éventuellement de l'aluminium. Sans sortir du cadre de l'invention, ledit nitrure de Gallium peut également comprendre d'autres éléments, par exemple métalliques, en substitution du Gallium, notamment utiles lors de son dépôt par pulvérisation cathodique, en proportion cependant très minoritaire.

De façon surprenante et non encore décrite dans les documents précédemment cités, il a été trouvé, et c'est là l'objet de la présente invention, qu'une telle couche, à la condition que son épaisseur soit inférieure à 20 nm, pouvait permettre l'obtention d'une cellule photovoltaïque finale de très bonne qualité, et présentant un rendement de conversion élevée, malgré les traitements thermiques successifs nécessaire à sa préparation, comme il est démontré par les exemples qui suivent.

Avantageusement, au dessus de cette couche 4 de nitrure de gallium éventuellement substituée par de l'aluminium, une couche supplémentaire 2 d'un matériau tampon est également déposée, telle que par exemple décrite dans le brevet US 6 169 246 ou encore dans la demande WO2009/156640.

Cette couche tampon a également un rôle d'isolation électrique entre l'électrode avant TCO et la couche fonctionnelle, et prévient des courts-circuits entre ces 2 couches et est un matériau qui présente, de préférence, une résistivité p d'un ordre de grandeur plus grande que la couche conductrice TCO, par exemple mais sans y être limité telle que 5 mΩ.cm < p < 200 Ω.cm.

En particulier, cette couche tampon peut être constituée d'un ou plusieurs matériaux choisis parmi les oxydes d'étain, de zinc, d'indium ou encore un oxyde mixte de zinc et d'étain, ledit oxyde mixte pouvant également éventuellement comprendre de l'aluminium et/ou de l'antimoine Sb dans des proportions pouvant aller jusqu'à 10% atomique pour chacun.

Par oxyde mixte on entend un oxyde comprenant dans sa structure cristalline et le plus souvent amorphe plusieurs éléments métalliques, chaque élément métallique étant présent à hauteur de plus de 10%, en pourcentage atomique rapporté à l'ensemble des éléments métalliques présents dans ledit oxyde.

Une telle couche peut notamment être obtenue par pulvérisation magnétron d'une cible constituée par un alliage SnₓZn_{y} (dopé éventuellement par au moins un des éléments Al ou Sb) sous atmosphère d'oxygène, x et y pouvant notamment varier continuellement entre 10 et 90% (atomique). Alternativement, ladite couche tampon peut être constituée par un oxyde mixte d'indium et d'étain, notamment obtenu par cette même technique de pulvérisation magnétron d'une cible d'un alliage de composition variable, en fonction de la composition recherchée de la couche d'oxyde mixte finalement déposée. L'épaisseur de ladite couche tampon est généralement comprise entre 20 et 300 nm, de préférence entre 100 et 250 nm, voire entre 150 et 200 nm.

L'empilement primaire 40 de couches minces ainsi formé sur le substrat de face avant 10 peut être par exemple déposé en continu dans un même appareillage, par les techniques connues de dépôt de couches minces sous vide, en particulier par les techniques de pulvérisation magnétron qui seront décrits par la suite.

L'empilement 40 est ensuite recouvert d'une couche photovoltaïque fonctionnelle 5 comprenant les matériaux à base de Cadmium telle que précédemment décrits, par exemple un film comprenant une hétérojonction CdS/CdTe, ledit film permettant la conversion énergétique entre les rayons lumineux et l'énergie électrique, tels que précédemment décrit.

La couche semi-conductrice photovoltaïque des cellules solaires selon l'invention peut utiliser une seule transition semi-conductrice (jonction simple) ou plusieurs transitions semi-conductrices (multi-jonction). Des couches semi-conductrices qui présentent la même transition interbande ne peuvent utiliser qu'une partie de la lumière solaire ; en revanche, des couches semi-conductrices qui présentent différentes transitions interbandes sont sensibles à une plus grande partie du spectre solaire.

Afin de former la seconde électrode supérieure, la couche fonctionnelle 5 est recouverte d'une couche conductrice 6, éventuellement transparente, de type TCO tel que précédemment décrit ou de type non transparente, comme par exemple en molybdène ou en un autre matériau métallique. Notamment, cette couche électrode peut être à base d'ITO (oxyde d'indium et d'étain) ou en métal (argent, or, cuivre, aluminium, molybdène), en oxyde d'étain dopé au fluor ou en oxyde de zinc dopé Al, Ga, B ou en stannate de Cadmium.

L'ensemble des couches minces 1-6 de l'empilement 30 est finalement emprisonné entre le substrat de face avant 10 et un substrat de face arrière 20 sous la forme d'une structure feuilletée, par l'intermédiaire d'un intercalaire thermoplastique 7 par exemple en PU, PVB ou EVA, pour former la cellule solaire finale 100.

La cellule photovoltaïque selon l'invention telle qu'elle vient d'être décrite peut être obtenue à l'aide d'un procédé comprenant au moins les étapes suivantes :
a) revêtir successivement et dans un même dispositif, la surface du substrat de face avant 10 par l'empilement de couches 40, comprenant la couche transparente d'oxyde électriquement conducteur et ses revêtements protecteur par la technique du dépôt sous vide par pulvérisation cathodique, éventuellement assistée par champ magnétique (« pulvérisation Magnétron »),
b) chauffer le substrat revêtu entre 300°C et 750°C dans une atmosphère, contenant de l'oxygène par exemple, pour le dépôt de la couche photovoltaïque à base de Cadmium, cette étape permettant également la cristallisation de la couche TCO,
c) éventuellement recuire à 400°C dans une atmosphère de CdCl₂,
d) déposer la couche électrode inférieure 6,
e) encapsuler l'empilement final de couches 30 entre le substrat de face avant 10 et le substrat de face arrière 20 par l'application du polymère thermoplastique 7, de manière à obtenir une structure feuilletée.

L'étape a), comprenant un dépôt sous vide par pulvérisation, est un procédé habituel et connu de réalisation de couches minces en matériaux qui se vaporisent avec difficulté. La surface d'un corps solide de composition appropriée, appelée cible, est pulvérisée par un tir d'ions riches en énergie provenant de plasmas à basse pression, par exemple des ions d'oxygène (O⁺) et/ou des ions d'argon (Ar⁺) ou des particules neutres, suite à quoi les matériaux pulvérisés se déposent en minces couches sur les substrats (voir Römpp Online, 2008, "Sputtering"). On utilise de préférence la pulvérisation soutenue par champ magnétique, souvent appelée pulvérisation magnétron. Selon l'invention, la pression partielle d'oxygène ou d'argon peut varier largement et être ainsi aisément adaptée aux besoins de chaque cas particulier. Par exemple, la puissance électrique nécessaire pour la pulvérisation peuvent être définis en fonction des dimensions des substrats transparents et de l'épaisseur des couches (en particulier de TCO) à déposer.

Dans le procédé selon l'invention, on réalise la pulvérisation des couches successivement dans des installations continues et déjà dimensionnées en conséquence, au moyen de cibles de pulvérisation appropriées. Selon l'invention, de préférence, on utilise de préférence une cible qui présente une composition correspondant sensiblement voire exactement à celle de la couche de TCO finalement obtenue sur le substrat. Dans ce cas il est possible d'utiliser, de manière avantageuse, la technique de pulvérisation soutenue par l'action d'un champ magnétique, souvent appelée pulvérisation magnétron. L'inconvénient de telles techniques est cependant que les couches obtenues présentent un faible taux de cristallinité des matériaux constitutifs, notamment des TCO et nécessite donc une étape de recuit pour recristalliser lesdits matériaux. Le dépôt de la couche de nitrure de gallium selon l'invention peut se faire notamment et de manière connue par une technique dite de pulvérisation réactive, comprenant la pulvérisation d'une cible de gallium métallique dans une atmosphère nitrurée, par exemple de N₂. Alternativement, il est également possible d'obtenir directement la couche de GaN sur le substrat par pulvérisation cathodique d'une cible déjà constituée du matériau GaN.

L'étape b) de dépôt des couches actives photovoltaïques à base de cadmium, de façon connue, est effectuée à chaud, c'est-à-dire à des températures supérieures à 400°C ou même à 700°C. Le dépôt des couches à base de Cadmium peut notamment être effectué par les techniques classiques pour le dépôt de telles couches, du type VTD (Vapor Transport Deposition), CSS (Close Space Sublimation), MOCVD (Metal Organica Vapor Deposition) ou PVD (Physical Vapor Deposition). Grâce à ce traitement thermique, la couche d'oxyde TCO est également rendue cristalline et sa résistivité décroit fortement.

L'électrode inférieure 6, c'est-à-dire tournée vers l'intérieure de la cellule par rapport au rayonnement incident, est de préférence réfléchissante dudit rayonnement. Son dépôt (étape d)) est réalisé de manière connue, notamment par une technique de dépôt sous vide.

Enfin, au cours de l'étape e) le substrat 20 de face arrière est assemblé à l'ensemble par feuilletage au moyen d'un film en matière plastique 16 du type polyvinyl butyral (PBV) ou éthylène-vinyl-acétate (EVA) selon des techniques bien connues d'obtention d'un vitrage feuilleté.

### Exemples :

Les exemples qui suivent sont fournis pour illustrer les avantages et les propriétés améliorés des réalisations selon l'invention. Ces exemples ne doivent en aucun être considérés, sous aucun des aspects décrits, comme limitatifs de la portée de la présente invention.

Dans un premier temps, on dépose sur un verre Diamant® commercialisé par la société SAINT-GOBAIN des couches successives selon la technique bien connu du dépôt sous vide par magnétron, dans les conditions habituelles, pour l'obtention d'un substrat muni d'une couche de protection 1 contre la migration des alcalins du verre en Si₃N₄ et d'une couche 3 de TCO, constituant l'électrode inférieure de la cellule. Plusieurs échantillons sont préparés sur la base de deux empilements conformes à l'invention (exemples 2 et 3), d'un empilement conforme à la technique connue à ce jour et préparé uniquement à des fins comparatives (exemple 1) et d'un empilement pour lequel l'épaisseur de la couche protectrice 4 n'est pas conforme à l'invention (exemple 4). Plus précisément, l'exemple 1 ne comporte pas de couche de protection au dessus de la couche TCO. Les exemples 2 et 3, conformes à l'invention, comportent additionnellement une couche en nitrure de gallium GaN de très faible épaisseur protégeant la couche TCO de l'oxydation lors d'un traitement thermique. La couche en nitrure de Gallium a été déposée par pulvérisation cathodique d'une cible de GaN.

Le tableau 1 ci-dessous indique plus en détails la composition des différents empilements préparés et leurs épaisseurs physiques (réelles).

**Tableau 1**

| Echantillon | Substrat verrier | Couche 1 (barrière aux alcalins) | Couche 3 (TCO) | Couche 4 (selon l'invention) |
|---|---|---|---|---|
| Exemple 1 | Diamant ® | Si₃N₄ 50 nm | AZO (ZnO : Al 2%)* 800 nm | - |
| Exemple 2 | Diamant ® | Si₃N₄ 50 nm | AZO (ZnO : Al 2%)* 800 nm | GaN 3 nm |
| Exemple 3 | Diamant ® | Si₃N₄ 50 nm | AZO (ZnO : Al 2%)* 800 nm | GaN 10 nm |
| Exemple 4 | Diamant ® | Si₃N₄ 50 nm | AZO (ZnO : Al 2%)* 800 nm | GaN 20 nm |

| | | | | |
|---|---|---|---|---|
| * ZnO dopé avec 2% d'Al, en pourcentage poids d'Al₂O₃ sur la masse total des oxydes | | | | |

Les variations des résistances par carré des différentes couches TCO des substrats des exemples 1 à 4 (ainsi que la transmission lumineuse T_{L} desdits substrats coté couche) ont été mesurées avant et après un recuit à 550°C pendant 9 minutes, représentatif des chauffages successifs imposés à la couche TCO lors de la fabrication standard d'une cellule selon l'invention. La résistance par carré des couches de TCO a été effectuée selon les techniques classiques, en utilisant la méthode quatre pointes ou méthode de Van Der Paw. Les mesures de T_{L} ont été effectuées selon l'illuminant D65, dans une gamme de longueurs d'onde comprise entre 300 et 2500 nm sur un spectromètre du type Perkin Elmer lambda 900. Les résultats sont reportés dans le tableau 2.

**Tableau 2**

| | | Avant recuit | | Après recuit 9 min | |
|---|---|---|---|---|---|
| Echantillon | empilement | R/_{carré} (Ohm/carré) | T_{L} (%) | R/_{carré} (Ohm/carré) | T_{L} (%) |
| Exemple 1 | verre Si₃N₄ / AZO | 14,7 | 74 | 80 | 84 |
| Exemple 2 | verre/Si₃N₄/AZO/GaN(3nm) | 14,5 | 71 | 15 | 84,1 |
| Exemple 3 | verre/AlN/AZO/GaN (10 nm) | 14,5 | 70 | 9 | 84,3 |
| Exemple 4 | verre / AlN / AZO/ GaN (20 nm) | 14,6 | 69 | 9 | 84,3 |

On voit par comparaison des données reportées dans le tableau 2, une différence de comportement significative entre les empilements des exemples 2 à 4 muni de la couche de protection 4 en GaN et l'empilement dépourvu de la couche GaN : pour un recuit de 9 minutes dans les mêmes conditions, la couche TCO selon l'exemple 1 présente une augmentation significative de sa résistance par carré alors que les couches TCO protégées par une fine couche de GaN selon l'invention (exemples 2 à 3) se caractérisent par des valeurs améliorées de leur conduction électrique. On remarque également que les propriétés de résistivité selon les exemples 2 à 4 sont proches, ce qui indique qu'une épaisseur de seulement quelques nm de la couche GaN s'avère suffisante pour protéger efficacement la couche de TCO de l'oxydation, ce qui n'avait jamais été décrit auparavant. On démontre qu'il est ainsi possible, pour des substrats incorporant la couche protectrice GaN selon l'invention, de prolonger de façon significative la durée des traitements thermiques subis par le substrat lors de la fabrication de la cellule photovoltaïque, sans dégrader significativement les propriétés, notamment conductrices, de la couche TCO.

Les performances de cellules photovoltaïques obtenues à partir des substrats selon les exemples 1 à 4 ont été mesurées en associant ceux-ci à une couche photovoltaïque de type CdS/CdTe.

Plus précisément, conformément à la cellule décrite selon la figure 1, sur les substrats selon les exemples 1 à 4, dont la durée de chauffage est ajustée de telle manière que la résistance de la couche TCO soit ajustée à 10 ohms/carré, on a déposé successivement selon les techniques classiques de pulvérisation magnétron une couche « tampon » d'un oxyde mixte d'étain et de zinc dans une proportion atomique 50/50 et d'épaisseur 75 nm, un film photovoltaïque de type CdS/CdTe et une électrode arrière de type argent. Les caractéristiques propres de la cellule (selon le modèle d'un circuit électrique équivalent pour une cellule solaire ou « solar cell équivalent » circuit selon le terme anglais) sont mesurées classiquement selon les paramètres habituels:
- Jsc : c'est la valeur en mA/cm² de densité de courant générée par le module solaire, à zéro volt (c'est-à-dire la densité de courant correspondant à un court circuit),
- Voc : c'est l'abréviation anglaise pour « open circuit voltage », c'est-à-dire la tension (en volts) en circuit ouvert,
- FF (%) : c'est l'abréviation anglaise pour le paramètre « Fill Factor », qui est défini comme la puissance maximale de la cellule divisée par la valeur de Jsc et de Voc.
- eff (%) : c'est l'efficacité solaire de la cellule, définie comme le pourcentage de puissance convertie (et collectée) à partir de la lumière absorbée pour une cellule solaire raccordée au circuit électrique. Ce terme est calculé en faisant le ratio du point de puissance maximum Pm par le produit de l'irradiance de la lumière incidente (E en W/m²) sous des conditions standard et la surface de la cellule solaire (en m²). Les conditions standards signifient une température de 25°C et une irradiance de 1000 W/m² selon le spectre AM1.5.

Les résultats obtenus sont regroupés dans le tableau 4 qui suit :

**Tableau 3**

| | eff (%) | FF (%) | Jsc (mA/cm²) | Voc (V) |
|---|---|---|---|---|
| Cellule obtenue à partir du substrat selon l'exemple 1 | 8,2 | 57 | 20,5 | 713 |
| Cellule obtenue à partir du substrat selon l'exemple 2 | 9,4 | 61 | 21,2 | 728 |
| Cellule obtenue à partir du substrat selon l'exemple 3 | 9,8 | 58 | 22,5 | 757 |
| Cellule obtenue à partir du substrat selon l'exemple 4 | 6,1 | 43 | 18 | 752 |

Les résultats indiqués dans le tableau 3 indiquent clairement que les cellules munies des couches de TCO protégées par une couche GaN selon l'invention présentent une efficacité solaire au moins équivalente, voire supérieure, aux cellules connues de l'art antérieur. En outre, une épaisseur trop importante de la couche de GaN, c'est-à-dire supérieure ou égale à 20 nm se traduit par une forte diminution de l'efficacité de la cellule.

Les expériences menées par la demanderesse ont également montrées que le remplacement de la couche de GaN par une couche de Si₃N₄ pourtant de très faible épaisseur (3 nm) entraîne un court-circuitage immédiat de la cellule.

Alternativement, le choix du matériau SiO₂ ou d'un nitrure alternatif du type NbN comme couche de protection de la couche TCO, n'a pas permis d'obtenir une protection quelconque contre l'oxydation dudit TCO. En particulier, aucune amélioration de la résistance par carré de la couche TCO finalement obtenue au sein de la cellule n'a été observée dans ce cas, par rapport à celle mesurée pour la cellule obtenue à partir du substrat selon l'exemple 1 (telle que reportée dans le tableau 4 qui précède).

De façon inattendue, les expériences menées montrent que seul le choix spécifique d'un matériau essentiellement en nitrure de gallium, combiné à une épaisseur de la couche nécessairement inférieure à 20 nm, permet une protection efficace de la couche TCO et même au final une amélioration sensible du rendement de la cellule photoélectrique.

## Revendications

1. Cellule photovoltaïque (100) comprenant au moins un substrat transparent verrier (10), protégeant un empilement de couches (30) comprenant au moins:
- un film (5) incorporant au moins un matériau à base de Cadmium et à propriétés photovoltaïques,
- deux couches (3, 6) formant électrodes de part et d'autre de ladite couche photovoltaïque (5), l'une inférieure (3) disposée la plus proche du substrat et l'autre supérieure (6),
au moins ladite couche électrode inférieure (3) étant un oxyde transparent conducteur du type TCO,
ladite cellule se caractérisant en qu'elle comprend, entre ladite couche électrode inférieure (3) et ledit film photovoltaïque (5), au moins une couche (4) constituée essentiellement d'un nitrure de gallium GaN, éventuellement partiellement substituée par de l'aluminium Al, ladite couche étant d'épaisseur physique strictement inférieure à 20 nm.

2. Cellule selon la revendication 1, dans laquelle la couche (4) constituée essentiellement d'un nitrure d'aluminium GaN présente une épaisseur inférieure à 15 nm, de préférence inférieure à 12 nm.

3. Cellule selon l'une des revendications précédentes dans laquelle le matériau à base de Cadmium et à propriétés photovoltaïques est du type CdS/CdTe.

4. Cellule selon l'une des revendications précédentes, comprenant en outre, entre la couche essentiellement en nitrure de Gallium (4) et le film (5) à propriétés photovoltaïques, une couche tampon (2) constituée d'un ou plusieurs matériaux choisis parmi l'oxyde d'étain SnO₂, l'oxyde de zinc ZnO, un oxyde mixte de zinc et d'étain de formulation générale SnₓZn_{y}O_{z}, comprenant également éventuellement de l'aluminium et/ou de l'antimoine Sb, ou un oxyde mixte d'indium et d'étain.

5. Cellule selon la revendication précédente, dans laquelle l'épaisseur physique de la couche tampon (2), est comprise entre 20 et 300 nm, de préférence entre 150 et 200 nm.

6. Cellule selon l'une des revendications précédentes, dans laquelle ladite couche électrode inférieure (3) est un TCO comprenant ou constitué par l'oxyde de zinc ZnO dopé par un élément choisi dans le groupe Al, Ga, In, B, Ti, V, Y, Zr, Ge ou par une combinaison de ces différents dopants, de préférence un TCO constitué par l'oxyde de zinc ZnO dopé à l'aluminium AZO ou l'oxyde de zinc ZnO dopé au gallium GZO ou l'oxyde de zinc ZnO co-dopé au gallium et à l'aluminium.

7. Cellule selon l'une des revendications 1 à 5, dans laquelle ladite couche électrode inférieure (3) est un TCO comprenant ou constitué par un stannate de Cadmium, notamment Cd₂SnO₄.

8. Cellule selon l'une des revendications précédentes dans laquelle le nitrure de gallium GaN constituant la couche (4) est partiellement substitué par de l'aluminium Al, dans une proportion comprise entre 1 et 50% atomique.

9. Cellule selon l'une des revendications précédentes, comprenant entre ledit substrat (10) et ladite couche électrode inférieure (3), au moins une couche de matériau diélectrique (1), constituée dans un matériau formant barrière aux alcalins issus du substrat verrier, notamment lors d'une trempe ou d'un recuit.

10. Cellule selon la revendication précédente, dans laquelle la couche (1) formant barrière aux alcalins comprend au moins un matériau choisi dans le groupe constitué par Si₃N₄, SnₓZn_{y}O_{z}, SiO₂, SiOₓN_{y}, TiO₂, Al₂O₃, ledit matériau étant éventuellement dopé notamment par un élément choisi parmi Al, Zr Sb.
